# EUROPÄISCHE PATENTSCHRIFT

(11) **EP 2 768 294 B1**
(45) Veröffentlichungstag und Bekanntmachung des Hinweises auf die Patenterteilung: **22.05.2019**
(21) Anmeldenummer: 13004726.9
(22) Anmeldetag: 30.09.2013
(51) Int. Cl.: H05K 3/46, H05K 1/05, H05K 3/36, H05K 3/40

(54) **Anordnung mit einer flexiblen Leiterplatte**
Assembly having a flexible circuit board
Agencement doté d'un circuit flexible

(30) Priorität: 08.01.2013 DE 102013000077
(43) Veröffentlichungstag der Anmeldung: 20.08.2014
(73) Patentinhaber: Mektec Europe GmbH, 41812 Erkelenz (DE)
(72) Erfinder: Kurpiers, Waldemar, 68782 Brühl (DE); Böhland, Heiko, 12309 Berlin (DE); Fischer, Peter, 51688 Wipperfuerth (DE)
(74) Vertreter: Wesch, Arno

(56) Entgegenhaltungen:
- EP-A1- 0 117 809
- EP-A1- 0 720 419
- EP-A1- 1 951 008
- WO-A1-2006/000694
- WO-A1-2009/035867
- US-A1- 2007 215 378

## Beschreibung

### Technisches Gebiet

Die Erfindung betrifft eine Anordnung gemäß dem Oberbegriff des Patentanspruchs 1.

### Stand der Technik

Eine solche Anordnung ist bereits aus der EP 1 951 008 A1 bekannt. Die EP 0 720 419 A1 zeigt eine starre Leiterplatte, die durch eine Ausnehmung flexibilisiert ist. Die US 2007/ 215 378 A1 offenbart eine starre Leiterplatte, deren Trägerlage mit Epoxidharz getränktes Papier aufweist. Die WO 20091035 867 A1 offenbart eine starre Leiterplatte mit mehreren Polymerlagen.

Aus dem Stand der Technik sind bereits starre Leiterplatten bekannt, welche eine Trägerlage aufweisen, auf welcher eine Isolationslage angeordnet ist. Auf der Isolationslage ist üblicherweise mindestens eine elektrische Leitung oder ein Netzwerk von elektrischen Leitungen angeordnet.

Eine solche starre Leiterplatte wird auch als IMS-Leiterplatte bezeichnet. Dies steht für "Insulated Metallic Substrate". Die Trägerlage kann aus Aluminium gefertigt sein, wobei die Isolationslage als Dielektrikum ausgestaltet ist. Die elektrische Leitung umfasst üblicherweise Kupfer. Die elektrische Leitung bildet eine so genannte "Layout-Lage".

Aus dem Stand der Technik sind des Weiteren flexible Leiterplatten, so genannte "Flexible Printed Circuits" (FPC), bekannt. Eine flexible Leiterplatte weist üblicherweise eine Trägerschicht aus Polyethylennaphthalat oder Polyimid auf. Auf dieser Trägerschicht sind ebenfalls elektrische Leitungen oder ein Netzwerk aus elektrischen Leitungen aufgebracht.

Aus der US 2007/215378 A1 ist bekannt, eine solche flexible Leiterplatte mit einer starren Leiterplatte zu verbinden, die eine Isolationslage, die beispielsweise aus Glasepoxid oder aus mit Phenolharz oder Epoxidharz getränktem Papier besteht, auf der Isolationslage eine Klebstofflage und auf der Klebstofflage eine Kupferfolie umfasst.

Darüber hinaus ist aus der WO 2009/035867 A1 eine Leiterplatte mit einem flexiblen und zwei starren Teilabschnitten bekannt, die eine erste Polymerlage, auf der ersten Polymerlage eine Leiterlage, auf der Leiterlage eine Klebstofflage und auf der Klebstofflage eine zweite Polymerlage umfasst, wobei die erste Polymerlage und die Klebstofflage teilweise entfernt worden sind, um den flexiblen Teilabschnitt der Leiterplatte auszubilden.

Vor diesem Hintergrund besteht das Bedürfnis nach einer überwachbaren und prozesssicheren Verbindung von einzelnen hoch wärmeleitenden starren Leiterplatten zu einer Verbundgruppe.

### Darstellung der Erfindung

Der Erfindung liegt daher die Aufgabe zugrunde, eine Anordnung der eingangs genannten Art derart auszugestalten und weiterzubilden, dass zwei starre Leiterplatten problemlos und zumindest geringfügig beweglich miteinander verbunden sind.

Die vorliegende Erfindung löst die zuvor genannte Aufgabe durch eine Anordnung mit den Merkmalen des Patentanspruchs 1.

Erfindungsgemäß ist erkannt worden, dass die starren Leiterplatten mittels einer flexiblen Leiterplatte elektrisch miteinander verbunden werden können. Dabei ist konkret erkannt worden, dass eine flexible Leiterplatte zwei starre Leiterplatten relativ beweglich zueinander positionieren kann. Darüber hinaus ist erkannt worden, dass eine Verbundgruppe aus starren Leiterplatten erzeugt werden kann, wobei auf die flexible Leiterplatte so genannte SMD-Bauteile aufgebracht werden können. Zwei starre Leiterplatten können zuverlässig unter Herstellung einer elektrischen Verbindung problemlos miteinander verbunden werden.

Folglich ist die eingangs genannte Aufgabe gelöst.

Vor diesem Hintergrund könnte die flexible Leiterplatte einen Spalt oder Abstand zwischen den starren Leiterplatten überspannen. Durch diese konkrete Ausgestaltung kann die flexible Leiterplatte als eine Art Scharnier fungieren. Zwei starre Leiterplatten können relativ zueinander verschwenkt werden, wobei die flexible Leiterplatte deformiert wird. Durch diese konkrete Ausgestaltung können mehrere starre Leiterplatten an einer flexiblen Leiterplatte hängend zu einem Verbund kombiniert werden.

Die beiden starren Leiterplatten könnten relativ zueinander bewegbar oder verschwenkbar sein. Durch diese konkrete Ausgestaltung können starre Leiterplatten problemlos in Gehäusen angeordnet und montiert werden.

Die flexible Leiterplatte könnte mittels eines Klebstoffs mit einer starren Leiterplatte verbunden sein. Durch einen Klebstoff erfolgt eine Fixierung der flexiblen Leiterplatte an der starren Leiterplatte.

Mindestens eine elektrische Leitung der flexiblen Leiterplatte könnte mit einer elektrischen Leitung einer starren Leiterplatte elektrisch leitend verbunden sein. Durch diese konkrete Ausgestaltung ist eine Durchkontaktierung gegeben.

Vor diesem Hintergrund könnte die elektrische Verbindung durch einen Kontaktstift und/ oder eine Lötverbindung erfolgen. Ein Kontaktstift kann sowohl die elektrische Leitung der flexiblen Leiterplatte als auch eine elektrische Leitung der starren Leiterplattedurchgreifen und so eine elektrisch leitende Verbindung herstellen.

Die elektrische Verbindung zwischen einer starren Leiterplatte (IMS) und einer flexiblen Leiterplatte (FPC) kann durch einen Lötprozess unter Verwendung eines Lotdepots realisiert werden. Ein Lötprozess ist kostengünstig. Die Lötverbindung kann alleine die elektrische Verbindung realisieren. Zusätzlich zu der Lötverbindung, aber auch alleine, kann ein weiteres Bauteil, beispielsweise ein Stift oder eine Hülse, gesetzt werden.

Die flexible Leiterplatte ist auf mindestens eine starre Leiterplatte auflaminiert. Durch die Auflaminierung werden elektrische Verbindungsstellen vor mechanischen Beschädigungen geschützt. Des Weiteren können elektrische Verbindungsstellen problemlos überwacht werden- Die elektrischen Verbindungsstellen stellen die Durchkontaktierung zwischen den elektrischen Leitungen der flexiblen Leiterplatte und der starren Leiterplatten dar.

Die flexible Leiterplatte könnte mit elektrischen Bauteilen bestückt sein. Die flexible Leiterplatte, welche als Verbindungselement für separate starre Leiterplatten dient, kann problemlos mit elektrischen Bauteilen, wie beispielsweise LEDs, bestückt werden. Hierdurch lassen sich Varianten von Schaltungen starrer Leiterplatten reduzieren.

Eine Anordnung der hier beschriebenen Art könnte als LED-Modul im Abblendlicht eines Kraftfahrzeugs verwendet werden, Konkret ist denkbar, LED-Module in automotiven Frontlichtapplikationen einzusetzen. Weiter ist denkbar, ein statisches Kurvenlicht, Fernlicht, Abblendlicht und Tagfahrlicht zu realisieren.

### Kurzbeschreibung der Zeichnung

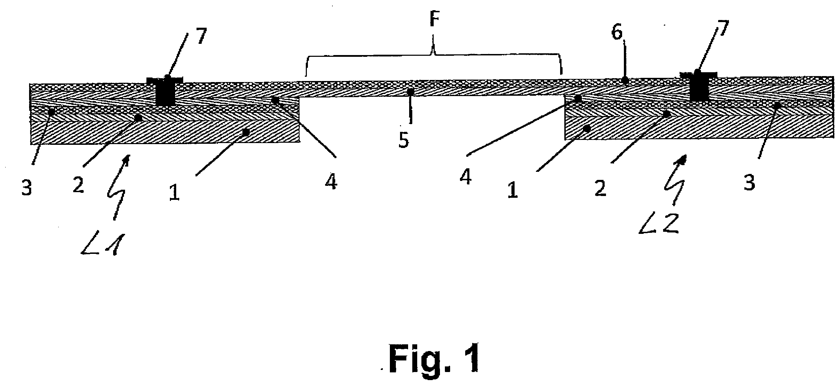

In der Zeichnung zeigt die einzige
- Fig. 1: eine Schnittzeichnung einer Anordnung der hier beschriebenen Art.

### Ausführung der Erfindung

Fig. 1 zeigt eine Anordnung, umfassend eine erste starre Leiterplatte L1 und eine zweite starre Leiterplatte L2, wobei jede der starren Leiterplatten L1, L2 je eine Trägerlage 1 umfasst, auf welcher je eine Isolationslage 2 angeordnet ist, und wobei auf der jeweiligen Isolationslage 2 mindestens je eine elektrische Leitung 3 angeordnet ist. Die starren Leiterplatten L1, L2 sind mittels einer flexiblen Leiterplatte 5, 6 mechanisch und/ oder elektrisch miteinander verbunden.

Die flexible Leiterplatte 5, 6 überspannt einen Spalt oder Abstand F zwischen den starren Leiterplatten L1, L2. Hierdurch wird ein flexibler Bereich der flexiblen Leiterplatte 5, 6 geschaffen, welcher nicht mit den starren Leiterplatten L1, L2 verbunden ist. Hierdurch sind die beiden starren Leiterplatten L1, L2 relativ zueinander bewegbar oder verschwenkbar.

Die flexible Leiterplatte 5, 6 ist mittels eines Klebstoffs 4 mit den starren Leiterplatten L1, L2 verbunden.

Mindestens eine elektrische Leitung 6 der flexiblen Leiterplatte 5, 6 ist mit einer elektrischen Leitung 3 einer starren Leiterplatte L1, L2 elektrisch leitend verbunden. Hierdurch erfolgt eine Durchkontaktierung zwischen der elektrischen Leitung 6 der flexiblen Leiterplatte 5, 6 und der elektrischen Leitung 3 der starren Leiterplatten L1, L2.

Die elektrische Verbindung erfolgt durch einen Kontaktstift 7 und/ oder eine Lötverbindung. Die flexible Leiterplatte 5, 6 ist auf die starren Leiterplatten L1, L2 auflaminiert.

Die flexible Leiterplatte 5, 6 ist mit elektrischen Bauteilen bestückt. Diese elektrischen Bauteile sind in der Figur nicht grafisch dargestellt.

Die in der Fig. 1 dargestellte Anordnung wird wie folgt hergestellt:
Die flexible Leiterplatte 5, 6 und die starren Leiterplatten L1, L2 werden mit dem Klebstoff 4 miteinander verbunden. Danach werden die elektrischen Leitungen 6, 3 der flexiblen Leiterplatte 5, 6 und der starren Leiterplatten L1, L2 elektrisch an vordefinierten Punkten miteinander verbunden. Dies wird als Durchkontaktierung bezeichnet.

Die Trägerlage 1 einer starren Leiterplatte L1, L2 kann aus Aluminium oder Keramik gefertigt sein. Die Isolationslage 2 ist bevorzugt als Dielektrikum oder Klebstoff ausgeführt.

Die elektrische Leitung 3 einer starren Leiterplatte L1, L2 ist aus Kupfer gefertigt.

Die flexible Leiterplatte 5, 6 weist eine Trägerschicht 5 auf, welche bevorzugt aus Polyethylennaphthalat oder Polyimid gefertigt ist. Die elektrische Leitung 6 der flexiblen Leiterplatte 5, 6 ist aus Kupfer gefertigt.

Auf der flexiblen Leiterplatte 5, 6 können elektrische Bauteile angeordnet sein. Die elektrischen Bauteile sind als sogenannte "Surface Mounted Devices" (SMD) ausgestaltet. Solche Bauteile sind oberflächenmontierte Bauteile. Im Gegensatz zur konventionellen Bestückung von elektrischen Leiterplatten werden diese Bauteile mit ihren Anschlussdrähten nicht in eine Platine gesteckt und auf der anderen Seite verlötet. Bei einer SMD-Technik erfolgt das Verlöten auf der gleichen Seite, auf der die Bestückung erfolgt.

## Patentansprüche

1. Anordnung, umfassend eine erste starre Leiterplatte (L1) und eine zweite starre Leiterplatte (L2), wobei jede der starren Leiterplatten (L1, L2) je eine Trägerlage (1) umfasst, welche aus Metall oder Keramik gefertigt ist und auf welcher je eine Isolationslage (2) angeordnet ist, wobei auf der jeweiligen Isolationslage (2) mindestens je eine elektrische Leitung (3) angeordnet ist und wobei die starren Leiterplatten (L1, L2) mittels einer flexiblen Leiterplatte (5, 6) mechanisch und/ oder elektrisch miteinander verbunden sind,
**dadurch gekennzeichnet, dass** die flexible Leiterplatte (5, 6) auf mindestens eine starre Leiterplatte (L1, L2) auflaminiert ist.

2. Anordnung nach Anspruch 1, **dadurch gekennzeichnet, dass** die starren Leiterplatten (L1, L2) IMS-Leiterplatten sind.

3. Anordnung nach Anspruch 1 oder 2, **dadurch gekennzeichnet, dass** die Trägerlage (1) aus Aluminium gefertigt ist.

4. Anordnung nach einem der voranstehenden Ansprüche, **dadurch gekennzeichnet, dass** die flexible Leiterplatte (5, 6) einen Spalt oder Abstand (F) zwischen den starren Leiterplatten (L1, L2) überspannt.

5. Anordnung nach einem der voranstehenden Ansprüche, **dadurch gekennzeichnet, dass** die beiden starren Leiterplatten (L1, L2) relativ zueinander bewegbar oder verschwenkbar sind.

6. Anordnung nach einem der voranstehenden Ansprüche, **dadurch gekennzeichnet, dass** die flexible Leiterplatte (5, 6) mittels eines Klebstoffs (4) mit einer starren Leiterplatte (L1, L2) verbunden ist.

7. Anordnung nach einem der voranstehenden Ansprüche, **dadurch gekennzeichnet, dass** mindestens eine elektrische Leitung (6) der flexiblen Leiterplatte (5, 6) mit einer elektrischen Leitung (3) einer starren Leiterplatte (L1, L2) elektrisch leitend verbunden ist.

8. Anordnung nach Anspruch 7, **dadurch gekennzeichnet, dass** die elektrische Verbindung durch einen Kontaktstift (7) und/oder eine Lötverbindung erfolgt.

9. Anordnung nach einem der voranstehenden Ansprüche, **dadurch gekennzeichnet, dass** die flexible Leiterplatte (5, 6) mit elektrischen Bauteilen bestückt ist.

10. Anordnung nach Anspruch 9, **dadurch gekennzeichnet, dass** die elektrischen Bauteile LEDs sind.

11. Verwendung der Anordnung nach Anspruch 10 als LED-Modul im Abblendlicht eines Kraftfahrzeuges und/oder in automotiven Frontlichtapplikationen wie statischem Kurvenlicht, Fernlicht, Abblendlicht und Tagfahrlicht.

## Claims

1. An assembly comprising a first rigid circuit board (L1) and a second rigid circuit board (L2), wherein each of the rigid circuit boards (L1, L2) comprises a carrier layer (1), which is made of metal or ceramic and on which an insulation layer (2) is respectively arranged, wherein at least one electric line (3) is arranged on each of the respective insulation layers (2), and wherein the rigid circuit boards (L1, L2) are mechanically and/or electrically connected to one another by means of a flexible circuit board (5, 6), **characterized in that** the flexible circuit board (5, 6) is laminated on at least one rigid circuit board (L1, L2).

2. The assembly according to claim 1, **characterized in that** the rigid circuit boards (L1, L2) are IMS circuit boards.

3. The assembly according to claim 1 or 2, **characterized in that** the carrier layer (1) is made of aluminum.

4. The assembly according to one of the preceding claims, **characterized in that** the flexible circuit board (5, 6) spans a gap or clearance (F) between the rigid circuit boards (L1, L2).

5. The assembly according to one of the preceding claims, **characterized in that** the two rigid circuit boards (L1, L2) can be moved or pivoted relative to one another.

6. The assembly according to one of the preceding claims, **characterized in that** the flexible circuit board (5, 6) is connected to a rigid circuit board (L1, L2) by means of an adhesive (4).

7. The assembly according to one of the preceding claims, **characterized in that** at least one electric line (6) of the flexible circuit board (5, 6) is connected to an electric line (3) of a rigid circuit board (L1, L2) in an electrically conductive manner.

8. The assembly according to claim 7, **characterized in that** the electrical connection is produced by means of a contact pin (7) and/or in the form of a soldered connection.

9. The assembly according to one of the preceding claims, **characterized in that** the flexible circuit board (5, 6) is populated with electrical components.

10. The assembly according to claim 9, **characterized in that** the electrical components are LEDs.

11. The utilization of the assembly according to claim 10 as an LED module in low-beam lights of a motor vehicle and/or in automotive front light applications such as static cornering lights, high-beam lights, low-beam lights and daytime running lights.

## Revendications

1. Agencement, comprenant une première carte de circuit imprimé rigide (L1) et une deuxième carte de circuit imprimé rigide (L2), chacune des cartes de circuit imprimé rigides (L1, L2) comprenant respectivement une couche porteuse (1), laquelle est fabriquée en métal ou en céramique et sur laquelle est placée respectivement une couche isolante (2), sur la couche isolante (2) respective étant placée au moins une ligne électrique (3) et les cartes de circuit imprimé rigides (L1, L2) étant assemblées l'une à l'autre de manière mécanique et/ou électrique à l'aide d'une carte de circuit imprimé souple (5, 6), **caractérisé en ce que** la carte de circuit imprimé souple (5, 6) est laminée sur au moins une carte de circuit imprimé rigide (L1, L2)

2. Agencement selon la revendication 1, **caractérisé en ce que** les cartes de circuit imprimé rigide (L1, L2) sont des cartes de circuit imprimé IMS.

3. Agencement selon la revendication 1 ou 2, **caractérisé en ce que** la couche porteuse (1) est fabriquée en aluminium.

4. Agencement selon l'une quelconque des revendications précédentes, **caractérisé en ce que** la carte de circuit imprimé souple (5, 6) enjambe une fente ou un écart (F) entre les cartes de circuit imprimé rigides (L1, L2).

5. Agencement selon l'une quelconque des revendications précédentes, **caractérisé en ce que** les deux cartes de circuit imprimé rigide (L1, L2) sont susceptibles d'être déplacées ou pivotées l'une par rapport à l'autre.

6. Agencement selon l'une quelconque des revendications précédentes, **caractérisé en ce que** la carte de circuit imprimé souple (5, 6) est reliée à l'aide d'un agent adhésif (4) avec une carte de circuit imprimé rigide (L1, L2)

7. Agencement selon l'une quelconque des revendications précédentes, **caractérisé en ce qu'**au moins une ligne électrique (6) de la carte de circuit imprimé souple (5, 6) est reliée de manière conductrice d'électricité avec une ligne électrique (3) d'une carte de circuit imprimé rigide (L1, L2).

8. Agencement selon la revendication 7, **caractérisé en ce que** la liaison électrique s'effectue à l'aide d'une broche de contact (7) et/ou d'une liaison par brasage.

9. Agencement selon l'une quelconque des revendications précédentes, **caractérisé en ce que** la carte de circuit imprimé souple (5, 6) est équipée de composants électriques.

10. Agencement selon la revendication 9, **caractérisé en ce que** les composants électriques sont des DEL.

11. Utilisation de l'agencement selon la revendication 10 sous la forme d'un module DEL dans les feux de croisement d'un véhicule automobile et/ou dans des applications d'optiques avant dans la branche automobile, comme l'éclairage statique en virage, les feux de route, les feux de croisement et les feux de diurnes.
